# EUROPÄISCHE PATENTANMELDUNG

(11) **EP 0 693 452 A1**
(43) Veröffentlichungstag der Anmeldung: **24.01.1996**
(21) Anmeldenummer: 95110349.8
(22) Anmeldetag: 03.07.1995
(51) Int. Cl.: B65H 75/18

(54) **Gurttrommel zum Aufspulen von auf Gurtbändern befestigten elektrischen Bauelementen**

(30) Priorität: 19.07.1994 DE 9411688 U
(71) Anmelder: SIEMENS MATSUSHITA COMPONENTS GmbH & CO KG, D-81617 München (DE)
(72) Erfinder: Pölzl, Horst, A-8544 Pölfing-Brunn (AT)
(74) Vertreter: Fuchs, Franz-Josef, Dr.-Ing.

(57) **Zusammenfassung**

Auf dem Trommelkern (2) einer Gurttrommel (1) zum Aufspulen von auf Gurtbändern (5) befestigten elektrischen Bauelementen (6) ist ein weiterer Trommelkern (8) drehbar vorgesehen.

## Beschreibung

Die vorliegende Erfindung betrifft eine Gurttrommel zum Aufspulen von auf Gurtbändern befestigten elektrischen Bauelementen nach dem Oberbegriff des Schutzanspruchs.

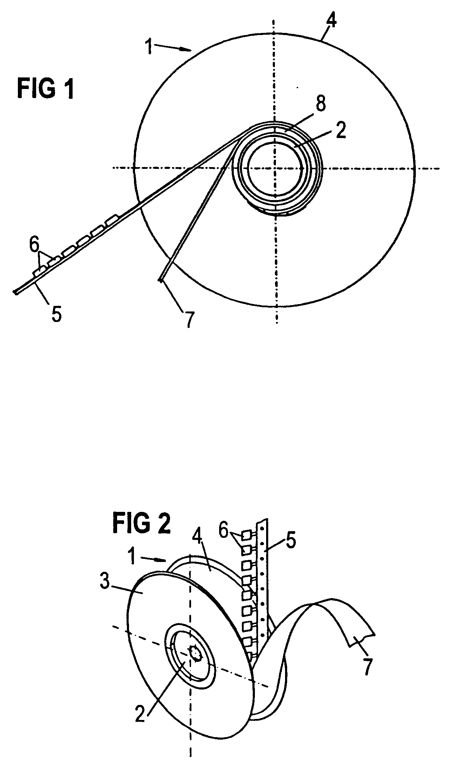

Eine Möglichkeit der Verpackung von auf Gurtbändern befestigten elektrischen Bauelementen ist die sogenannte Rollenverpackung, bei der auf Gurtbändern befestigte elektrische Bauelemente auf eine Gurttrommel aufgespult werden. Eine derartige Verpackungsart ist aus dem Datenbuch "Thermistoren" der Anmelderin, Ausgabe 1993, Seite 310 bekannt. Figur 2 zeigt in schematischer perspektivischer Darstellung diese Art der Verpackung. Dabei ist eine Gurttrommel 1 mit einem Trommelkern 2 sowie an diesem befestigten einen Wickelraum bildenden Trommelflanschen 3, 4 vorgesehen. Auf einem Gurtband 5 ist eine Folge von elektrischen Bauelementen 6 befestigt. Das Gurtband 5 mit den darauf befindlichen elektrischen Bauelementen 6 wird zusammen mit einem Zwischenlageband 7 beispielsweise mittels eines Klebebandes am Trommelkern 2 der Gurttrommel 1 befestigt. Durch Rotationsbewegung der Gurttrommel 1 werden das Gurtband 5 und das Zwischenlageband 7 auf den Trommelkern 2 aufgewickelt.

Durch den beim Aufspulen entstehenden Zug kommt es speziell bei den in der Nähe des Trommelkerns 2 befindlichen Gurtbandlagen zu einer extrem harten Wicklung, die fallweise zum Verbiegen der Bauelemente 6 führen kann.

Da bei Bauelemente-Anwendern in der Regel ein automatischer Bestückvorgang durchgeführt wird, kommt es beim Abwickeln des Gurtbandes 5 und des Zwischenlagebandes 7 erneut zu einer starken Zugbeanspruchung am Gurtband 5, wodurch ein stärkeres Verbiegen der Bauelemente 6 auftreten kann. Da das Verbiegen der Bauelemente 6 sowohl beim Aufspulen als auch beim Abspulen nicht ausgeschlossen werden kann, führt dies zwangsläufig zu Bestückungsproblemen.

Der vorliegenden Erfindung liegt die Aufgabe zugrunde, eine Gurttrommel der in Rede stehenden Art so auszubilden, daß das vorstehend erläuterte Problem des Bauelementeverbiegens ausgeschlossen ist.

Diese Aufgabe wird bei einer Gurttrommel der eingangs genannten Art erfindungsgemäß durch das Merkmal des kennzeichnenden Teils des Schutzanspruchs gelöst.

Die Erfindung wird nachfolgend anhand eines Ausführungsbeispiels gemäß den Figuren der Zeichnung näher erläutert. Es zeigt:
- Figur 1: eine Ausführungsform einer neuerungsgemäß ausgebildeten Gurttrommel; und
- Figur 2: die oben bereits erläuterte bekannte Ausführungsform der Gurttrommel.

Bei der erfindungsgemäßen Ausführungsform einer Gurttrommel nach Figur 1, in der gleiche Elemente wie in Figur 2 mit gleichen Bezugszeichen versehen sind, ist auf dem Trommelkern 2 ein weiterer drehbarer Trommelkern 8 vorgesehen, an dem das Gurtband 5 und das Zwischenlageband 7 beispielsweise durch Kleben befestigt sind.

Bei einem Auf- und Abspulen des Gurtbandes 5 mit dem Zwischenlageband 7 dreht sich der weitere Trommelkern 8 um den festen innenliegenden Trommelkern 2 der Gurttrommel 1. Die durch die Drehbewegung der Gurttrommel 1 entstehende Zugbeanspruchung wird durch den durchrutschenden weiteren Trommelkern 8 aufgenommen, so daß es zu keiner Deformierung bzw. Verbiegung der gegurteten Bauelemente 6 kommen kann.

## Patentansprüche

1. Gurttrommel (1) zum Aufspulen von auf Gurtbändern (5) befestigten Bauelementen (6) mit einem Trommelkern (2) und am Trommelkern (2) vorgesehenen einen Wickelraum bildenden Trommelflansch (3, 4),
**gekennzeichnet durch**
einen weiteren auf dem Trommelkern (2) vorgesehenen und auf diesem drehbaren Trommelkern (8).
